# EUROPÄISCHE PATENTSCHRIFT

(11) **EP 3 717 143 B1**
(45) Veröffentlichungstag und Bekanntmachung des Hinweises auf die Patenterteilung: **16.10.2024**
(21) Anmeldenummer: 18804581.9
(22) Anmeldetag: 15.11.2018
(51) Int. Cl.: B21B 21/00

(54) **WALZGERÜST**
ROLL STAND
CAGE DE LAMINAGE

(30) Priorität: 27.11.2017 DE 102017221126
(43) Veröffentlichungstag der Anmeldung: 07.10.2020
(73) Patentinhaber: SMS group GmbH, 41069 Mönchengladbach (DE)
(72) Erfinder: BAENSCH, Michael, 41749 Viersen (DE); THOME, Verena, 47877 Willich (DE)
(74) Vertreter: Kross, Ulrich
(86) Internationale Anmeldenummer: PCT/EP2018/081447
(87) Internationale Veröffentlichungsnummer: WO 2019/101628

(56) Entgegenhaltungen:
- EP-A1- 1 240 955
- EP-A1- 2 957 365
- WO-A1-2004/018132
- WO-A1-2014/160695
- WO-A1-2016/149774
- WO-A1-2016/190076
- WO-A1-2017/040403
- DE-A1- 102014 210 201
- DE-B- 1 287 541
- DE-U1- 29 980 239

## Beschreibung

Die Erfindung betrifft ein Walzgerüst nach dem Oberbegriff des Anspruchs 1 sowie ein Verfahren zur Verbesserung einer bestehenden Walzanlage.

DE 1 287 541 B beschreibt ein Walzengerüst für ein Mehrfach-Kaltpilgerwalzwerk.

Ein Walzgerüst ist aus zwei Walzenständern bzw. Gerüstseiten aufgebaut, die mittels montierten Abstandsbolzen miteinander verbunden sind. Bei einem solchen Kaltpilgerwalzwerk ist das Walzgerüst nicht stationär angeordnet, sondern wird mittels eines Antriebs alternierend bewegt.

Es ist die Aufgabe der Erfindung, ein Walzgerüst anzugeben, das bei gegebenen Walzkräften ein geringes Gewicht aufweist.

Diese Aufgabe wird für ein eingangs genanntes Walzgerüst erfindungsgemäß mit den kennzeichnenden Merkmalen des Anspruchs 1 gelöst. Durch die Herstellung des Walzgerüstes mittels einer additiven Fertigung wird eine besonders große Freiheit in der Formgebung erzielt, so dass die für das Walzgerüst notwendige Materialmenge reduziert werden kann.

Unter einer additiven Fertigung wird vorliegend verstanden, dass nach dem Prinzip des "3-D-Drucks" eine als Datensatz gegebene Form bzw. Gestaltdefinition sukzessive durch Anfügen kleinster Materialmengen aufgebaut wird.

Eine Walze wird im Sinne der vorliegenden Erfindung insbesondere als in dem Walzgerüst drehbar aufgenommene Einheit verstanden, die zudem eine Werkzeugfläche zur Ausführung des Walzvorgangs umfasst. In zweckmäßiger Bauart kann eine solche Walze aus einer Walzenwelle und einem darauf angebrachten Walzenkörper als Werkzeug ausgebildet sein. Der Walzenkörper kann bevorzugt als austauschbares Bauteil ausgebildet sein. Die Verbindung mit der Walzenwelle kann besonders bevorzugt durch Aufschrumpfen des Walzenkörpers auf die Walzenwelle erfolgen.

Es kann vorteilhaft sein, wenn eine additive Fertigung indirekt erfolgt, wobei eine Gussform des Walzgerüstes unmittelbar durch additive Fertigung hergestellt wird. Dies ist jedoch nicht Gegenstand der beanspruchten Erfindung. Durch dieses Vorgehen können herkömmliche, gut kontrollierbare Gießverfahren zur Erzielung einer hohen Materialstärke mit einer erweiterten Flexibilität der Formgebung kombiniert werden. Bevorzugte Gießmaterialien sind Stahl oder Eisenguss. Besonders bevorzugt wird vorliegend Eisenguss verwendet.

Gemäß der Erfindung ist es vorgesehen, dass das Walzgerüst teilweise unmittelbar durch additive Fertigung ausgebildet wird. Dies erlaubt eine maximale Flexibilität der Formgebung, wobei bezüglich des verwendeten Materials eine entsprechende Kompatibilität mit dem additiven Verfahren bestehen muss.

Es ist insbesondere möglich, die vorstehend erläuterten Verfahren, also direkte und indirekte additive Fertigung, an demselben Walzgerüst zu kombinieren.

Je nach Anforderungen können Teile des Walzgerüstes, die bezüglich Festigkeit und/oder Gewicht weniger kritisch sind, aus herkömmlichen Bauteilen, insbesondere Standard-Halbzeug wie etwa Platten, bestehen.

Allgemein vorteilhaft betrifft die Erfindung Walzgerüste aus einem eisenbasierten Werkstoff mit einer Gesamtmasse von mehr als 0,5 Tonnen.

Allgemein vorteilhaft ist es vorgesehen, dass das Walzgerüst als im Zuge eines Walzvorgangs antreibbar bewegbare Einheit ausgebildet ist. Besonders bevorzugt kann es sich dabei um ein Kaltpilger-Walzgerüst handeln.

Bei solchen bewegbaren Walzgerüsten hängt die erzielbare Geschwindigkeit des Walzvorgangs vorrangig von der Masse und Festigkeit des Walzgerüstes ab, so dass ein erfindungsgemäß optimiertes Walzgerüst eine Steigerung des Durchsatzes erlaubt. Insbesondere ist es möglich, durch die erfindungsgemäße Optimierung von Kaltpilger-Walzgerüsten eine Steigerung der Hubzahlen beim Kaltpilgerwalzen von mehr als 10%, insbesondere mehr als 15%, zu erzielen, wobei die Masse des Walzgerüstes bei gegebenen Walzkräften um mehr als 10% gegenüber herkömmlichen Walzgerüsten reduziert ist.

Bei einer bevorzugten Weiterbildung ist es dabei vorgesehen, dass an dem Walzgerüst zumindest ein Kurbelzapfen zum Bewegen des Walzgerüsts aufgenommen ist, wobei der Kurbelzapfen besonders bevorzugt nicht mittels der additiven Fertigung ausgebildet ist. Dies erlaubt eine besonders belastbare Auslegung des Kurbelzapfens oder auch die Auslegung als wechselbares Verschleißteil. Bei einer alternativen Ausführungsform kann der Kurbelzapfen aber ebenfalls mittels der additiven Fertigung ausgebildet sein.

Erfindungsgemäß ist es vorgesehen, dass das Walzgerüst zwei Gerüstseiten umfasst, wobei die Walzen zwischen den Gerüstseiten verlaufen und in den Gerüstseiten gelagert sind. Dabei sind die Gerüstseiten durch Querstreben materialeinheitlich einstückig miteinander verbunden, wobei die Querstreben gemeinsam mit den Gerüstseiten mittels der additiven Fertigung hergestellt sind. Dies erlaubt eine besonders große Steifigkeit des Walzgerüstes bei geringem Gewicht.

Allgemein bevorzugt ist es vorgesehen, dass eine Form des Walzgerüstes mittels einer Rechneroptimierung unter Verwendung der Finite-Elemente-Methode im Hinblick auf Masse und/oder Festigkeit optimiert ist. Dies erlaubt eine ideale Kombination mit den Vorteilen einer additiven Fertigung.

Die Aufgabe der Erfindung wird zudem gelöst durch ein Verfahren zur Verbesserung einer bestehenden Walzanlage, umfassend die Schritte:
a. Aufnahme von Rahmenparametern eines bestehenden Walzgerüstes;
b. Entwurf eines bezüglich wenigstens einer Eigenschaft, bevorzugt Masse und/oder Festigkeit, optimierten Walzgerüstes unter Einhaltung der in Schritt a. aufgenommenen Rahmenparameter;
c. Fertigung eines neuen Walzgerüstes mittels additiver Fertigung nach einem der Ansprüche 1-5,
d. Austausch des bestehenden Walzgerüstes durch das neue Walzgerüst.

Auf diese Weise kann ein bestehendes Kaltpilger-Walzwerk in seiner Leistung gesteigert werden. Das neue Walzgerüst kann durch entsprechende Optimierung leichter und/oder fester als das bestehende Walzgerüst sein, so dass nach Austausch der Walzgerüste zum Beispiel eine höhere Hubfrequenz gefahren werden kann. Dies erlaubt die Verbesserung der Produktivität bestehender Anlagen zu relativ geringen Kosten.

Nachfolgend wird ein bevorzugtes Ausführungsbeispiel der Erfindung beschrieben und anhand der anliegenden Zeichnungen näher erläutert.
- Fig. 1: zeigt eine räumliche Ansicht eines Kaltpilger-Walzgerüstes mit eingebauten Walzen nach dem Stand der Technik.
- Fig. 2: zeigt eine räumliche Ansicht eines erfindungsgemäßen Kaltpilger-Walzgerüstes, das das Walzgerüst aus Fig. 1 ersetzen kann.
- Fig. 3: zeigt eine weitere räumliche Ansicht des Walzgerüstes aus Fig. 2.
- Fig. 4: zeigt eine Aufsicht von der Seite auf das Walzgerüst aus Fig. 2.
- Fig. 5: zeigt eine weitere räumliche Ansicht des Walzgerüstes aus Fig. 2.

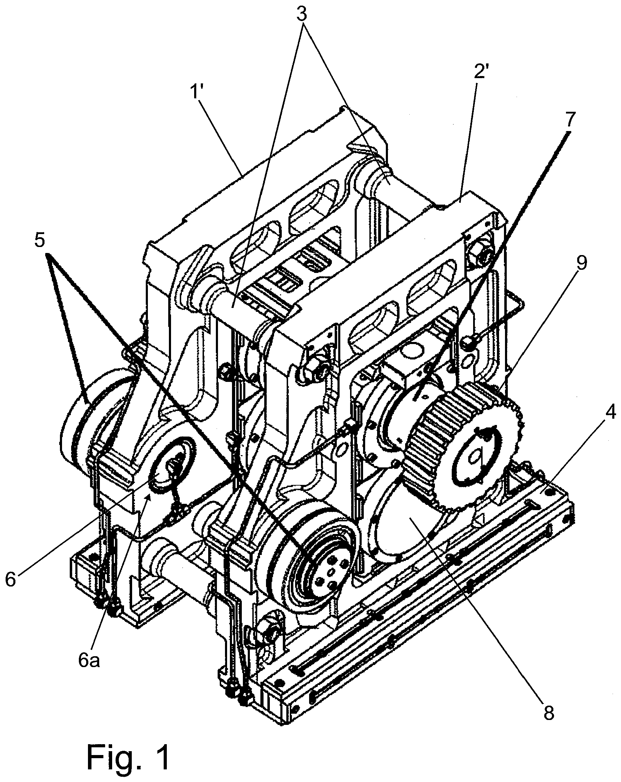

Das in Fig. 1 gezeigte, vorbekannte Walzgerüst einer Kaltpilger-Walzvorrichtung umfasst zwei Gerüstseiten 1', 2`, die durch eine Anzahl von separaten Verbindungsbolzen 3 zu einem Gerüst montiert sind. Das Walzgerüst ins insgesamt antreibbar bewegbar, wobei in einem unteren Bereich Halteglieder zur beweglichen Lagerung an einem stationären Schienensystem (nicht dargestellt) vorgesehen sind. Zum Antrieb des Walzgerüstes greifen Pleuelstangen einer Antriebseinheit (nicht dargestellt) an Lagern 5 an. Die Lager 5 sind an Kurbelzapfen 6 aufgenommen, die ihrerseits in Aufnahmen 6a in den Gerüstseiten 1', 2' fixiert sind. Durch die Pleuel wird das Walzgerüst mit einer bestimmten Hubfrequenz alternierend translatorisch bewegt.

In den Gerüstseiten 1', 2' sind wenigstens zwei Walzen 7, 8 aufgenommen bzw. gelagert. Eine Drehung der beiden Walzen 7, 8 ist über Zahnräder 9 und ortsfeste Zahnstangen (nicht dargestellt) an die translatorische Bewegung des Walzgerüstes gekoppelt.

Ein rohrförmiges Werkstück (nicht dargestellt) läuft zwischen den Walzen 7, 8 hindurch und über einen Dorn (nicht dargestellt). Durch die alternierende Bewegung des Walzgerüstes in Verbindung mit einer entsprechenden Führung des Werkstücks erfolgt auf bekannte Weise eine Umformung nach dem Kaltpilger-Walzverfahren. Dabei wird die zwischen den Walzen 7, 8 auftretende Walzkraft durch das Walzgerüst 1', 2', 3 abgestützt.

Im vorliegenden Beispiel hat das vorbekannte Walzgerüst 1', 2', 3 (ohne Walzen und weitere Einbauten) eine Masse von etwa 890 kg. Die alternierende Bewegung erfolgt mit einer maximalen Hubfrequenz von 200 Hüben pro Minute.

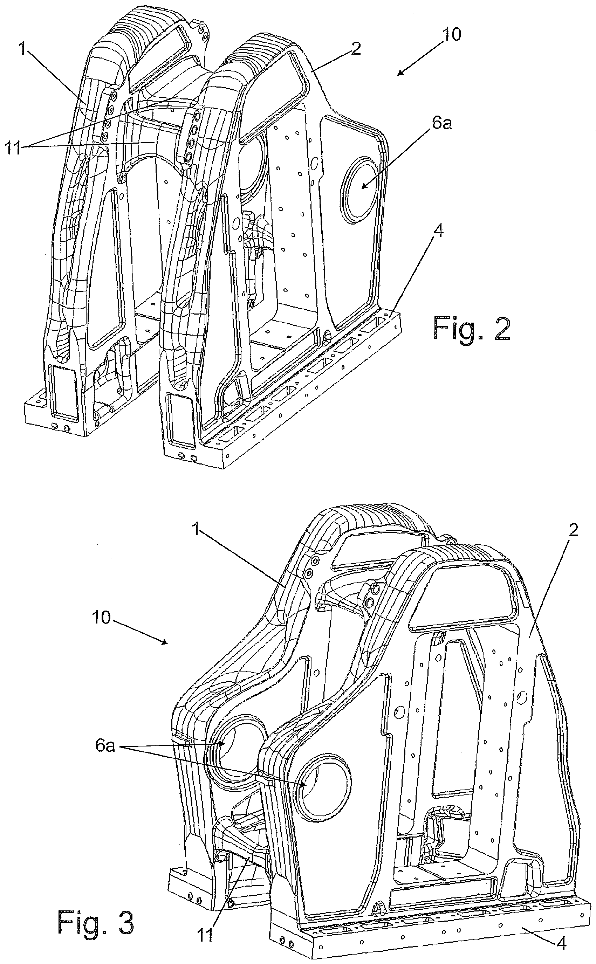

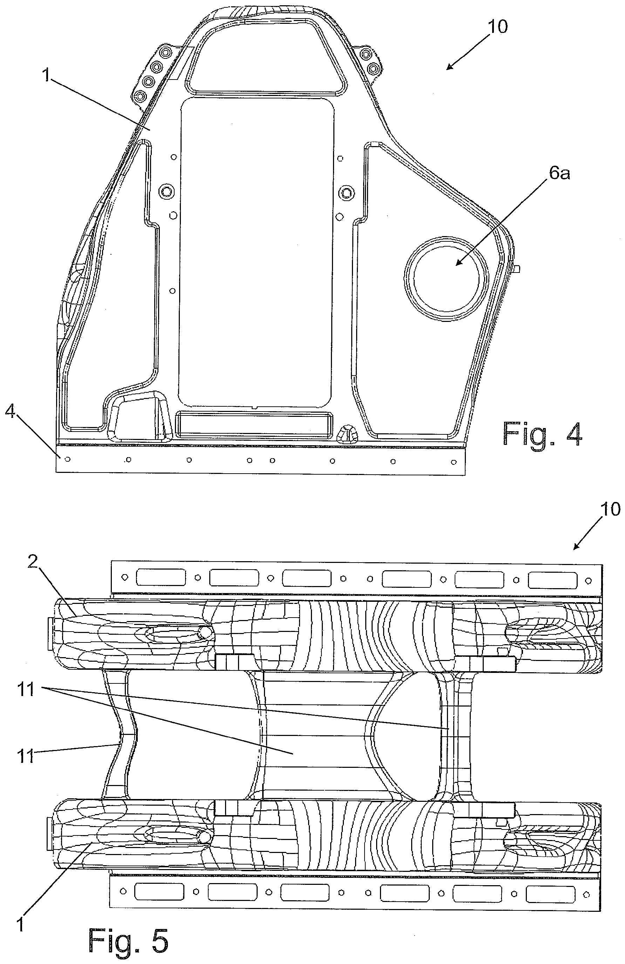

Fig. 2 bis Fig. 5 zeigen ein erfindungsgemäßes Walzgerüst 10 aus Gusseisen. Die Form dieses Walzgerüstes 10 wurde auf einem Rechner mit Hilfe der Finite-Elemente-Methode optimiert, um bei gegebener Festigkeit die Masse des Gerüstes zu minimieren.

Ausgangspunkt für die Optimierung waren bekannte Rahmendaten für die Abmessungen und Mindestfestigkeiten des vorbekannten Walzgerüstes 1', 2', 3. Mittels der Finite-Elemente-Methode wurde dann die Form des Gerüstes optimiert. Bei der Optimierung war ein Kriterium, dass das Gerüst im Prinzip gießbar sein soll, bei der Herstellung der Gießform bezüglich Hinterschneidungen etc. nahezu vollständige Gestaltungsfreiheit herrscht.

Als Vorgabe wurde die erreichbare Hubfrequenz auf 250 Hübe pro Minute erhöht. Dies erforderte eine verstärkte Gestaltung insbesondere der Bereiche um die Kurbelzapfen 6.

Die Herstellung des berechneten Gerüstes gemäß Fig. 2 bis Fig. 5 erfolgt dann über eine indirekte additive Fertigung. Dabei wird die Gussform durch eine Anlage zum 3-D-Druck durch additive Fertigung hergestellt. Mittels dieser additiv gefertigten Gussform wird dann das Walzgerüst 10 gegossen. Vorliegend wird als Gussmaterial Eisenguss verwendet.

Das auf diese Weise gefertigte Walzgerüst 10 hat trotz der auf 250 Hübe pro Minute erhöhten Hubfrequenz eine Masse von rund 800 kg und eine erhöhte Festigkeit.

Gemäß einem erfindungsgemäßen Verfahren zur Verbesserung bestehender Walzanlagen wird das bestehende, in Fig. 1 gezeigte Gerüst 1, 2, 3 einer bestehenden und in Betrieb befindlichen Walzanlage durch das neue Gerüst 10 ersetzt. Dies erlaubt aufgrund der verringerten Gerüstmasse in der Regel eine Erhöhung der Hubfrequenz der Walzanlage, ohne dass die Antriebsvorrichtung größere Änderungen erfahren muss.

Die Kurbelzapfen 6 sind auch bei dem additiv gefertigten Walzgerüst 10 als separate Bauteile vorgesehen, die in Aufnahmen 6a fixiert werden. Diese Kurbelzapfen und ihre Aufnahmen 6a gehören zu den mechanisch am stärksten beanspruchten Stellen des Walzgerüstes. Die durch die Finite-Elemente-Methode ermittelte Formgebung resultiert in einer bionischen Formgebung des Walzgerüstes 10 mit vielen verrundeten Bereichen. Insbesondere kritische Stellen wie der Bereich um die Aufnahmen 6a der Kurbelzapfen 6 sind dabei relativ verstärkt. Bei weniger kritischen Bereichen konnte das Gerüstmaterial relativ ausgedünnt und eingespart werden.

Anders als bei dem herkömmlichen Walzgerüst 1', 2', 3 sind Gerüstseiten 1, 2 des erfindungsgemäßen Walzgerüstes 10 mittels materialeinheitlich einstückig ausgebildeten Querstreben 11 verbunden. Die Querstreben 11 werden zusammen mit den Gerüstseiten 1, 2 durch die (indirekte) additive Fertigung bzw. durch den Gussvorgang hergestellt.

Die Walzen 7, 8 sind vorliegend als in dem Walzgerüst 10 drehbar aufgenommene Einheit verstanden, die aus einer Walzenwelle und einem darauf angebrachten Walzenkörper (nicht dargestellt) ausgebildet ist. Eine Werkzeugfläche zur Ausführung des Walzvorgangs wird durch den Walzenkörper als Werkzeug gebildet. Der Walzenkörper ist als austauschbares Bauteil ausgebildet. Die Verbindung mit der Walzenwelle erfolgt vorliegend durch Aufschrumpfen des Walzenkörpers auf die Walzenwelle. Wenn der Walzenkörper von der Walzenwelle gelöst wird, kann die Walzenwelle seitlich aus dem Walzgerüst 10 herausgenommen werden. Eine Trennung der Gerüstseiten 1, 2 ist somit nicht erforderlich.

Es versteht sich, dass das vorstehend beschriebene Walzgerüst auch erfindungsgemäß durch direkte additive Fertigung hergestellt werden kann. Bei der berechneten Formgebung sind die Eigenschaften des additiv zusammengefügten Gerüstmaterials entsprechend zu berücksichtigen.

### Bezugszeichenliste

- 1': erste Gerüstseite Stand der Technik
- 1: erste Gerüstseite, erfindungsgemäß
- 2`: zweite Gerüstseite Stand der Technik
- 2: zweite Gerüstseite, erfindungsgemäß
- 3: Verbindungsbolzen
- 4: Halteglieder
- 5: Lager für Antriebseinheit
- 6: Kurbelzapfen
- 6a: Aufnahme für Kurbelzapfen
- 7: erste Walze
- 8: zweite Walze
- 9: Zahnrad zum Walzenantrieb
- 10: additiv gefertigtes Walzgerüst
- 11: Querstreben, materialeinheitlich einstückig

## Patentansprüche

1. Walzgerüst (10), wobei zumindest zwei Walzen (7, 8) zur Umformung eines Werkstücks in dem Gerüst aufgenommen sind, und
wobei eine beim Umformen wirkende Walzkraft durch das Walzgerüst (10) abgestützt wird,
**dadurch gekennzeichnet,**
**dass** das Walzgerüst (10) teilweise unmittelbar durch additive Fertigung ausgebildet ist, wobei
das Walzgerüst (10) zwei Gerüstseiten (1, 2) umfasst, wobei die Walzen (7, 8) zwischen den Gerüstseiten (1, 2) verlaufen und in den Gerüstseiten (1, 2) gelagert sind und
die Gerüstseiten (1, 2) durch Querstreben (11) materialeinheitlich einstückig miteinander verbunden sind, wobei die Querstreben (11) gemeinsam mit den Gerüstseiten (1, 2) mittels der additiven Fertigung hergestellt sind.

2. Walzgerüst (10) nach Anspruch 1, **dadurch gekennzeichnet, dass** das Walzgerüst (10) als im Zuge eines Walzvorgangs antreibbar bewegbare Einheit ausgebildet ist.

3. Walzgerüst nach Anspruch 2, **dadurch gekennzeichnet, dass** das Walzgerüst (10) als Kaltpilger-Walzgerüst ausgebildet ist.

4. Walzgerüst nach Anspruch 3, **dadurch gekennzeichnet, dass** an dem Walzgerüst (10) zumindest ein Kurbelzapfen (6) zum Bewegen des Walzgerüstes (10) aufgenommen ist, wobei insbesondere der Kurbelzapfen (6) nicht mittels der additiven Fertigung ausgebildet ist.

5. Walzgerüst nach einem der vorhergehenden Ansprüche, **dadurch gekennzeichnet, dass** eine Form des Walzgerüstes mittels einer Rechneroptimierung unter Verwendung der Finite-Elemente-Methode im Hinblick auf Masse und/oder Festigkeit optimiert ist.

6. Verfahren zur Verbesserung einer bestehenden Walzanlage, umfassend die Schritte:
a. Aufnahme von Rahmenparametern eines bestehenden Walzgerüstes (1, 2, 3);
b. Entwurf eines bezüglich wenigstens einer Eigenschaft, insbesondere Masse und/oder Festigkeit, optimierten Walzgerüstes (10) unter Einhaltung der in Schritt a. aufgenommenen Rahmenparameter;
c. Fertigung eines neuen Walzgerüstes (10) mittels additiver Fertigung nach einem der vorhergehenden Ansprüche,
d. Austausch des bestehenden Walzgerüstes (1, 2, 3) durch das neue Walzgerüst (10).

## Claims

1. Roll stand (10), wherein at least two rolls (7, 8) for reshaping a workpiece are mounted in a stand, and
wherein a rolling force acting during the reshaping is supported by the roll stand (10),
**characterised in that**
the roll stand (10) is constructed in part directly by additive manufacture, wherein
the roll stand (10) comprises two stand sides (1, 2), wherein the rolls (7, 8) extend between the stand sides (1, 2) and are mounted in the stand sides (1, 2) and
the stand sides (1, 2) are integrally connected together with material unity by transverse struts (11), wherein the transverse struts (11) are produced in common with the stand sides (1, 2) directly by means of the additive manufacture.

2. Roll stand (10) according to claim 1, **characterised in that** the roll stand (10) is configured as a movable unit drivable in the course of a rolling process.

3. Roll stand according to claim 2, **characterised in that** the roll stand (10) is constructed as a cold pilger roll stand.

4. Roll stand according to claim 3, **characterised in that** at least one crank pin (6) for movement of the roll stand (10) is mounted at the roll stand (10), wherein, in particular, the crank pin (6) is not constructed by means of the additive manufacture.

5. Roll stand according to any one of the preceding claims, **characterised in that** a shape of the roll stand is optimised with respect to mass and/or strength by means of computer optimisation with use of the finite element method.

6. Method for improving an existing rolling plant, comprising the steps:
a. recording framework parameters of an existing roll stand (1, 2, 3);
b. design of a roll stand (10), which is optimised with respect to at least one characteristic, particularly mass and/or strength, with maintenance of the framework parameters recorded in step a.;
c. manufacture of a new roll stand (10) by means of additive manufacture according to any one of the preceding claims;
d. exchange of the existing roll stand (1, 2, 3) by the new roll stand (10).

## Revendications

1. Châssis de laminoir (10), dans lequel au moins deux rouleaux (7, 8) pour la transformation d'une pièce sont montés dans le châssis, et
dans lequel une force de laminage agissant lors de la transformation est supportée par le châssis de laminoir (10),
**caractérisé en ce que**
le châssis de laminoir (10) est partiellement formé directement par fabrication additive,
le châssis de laminoir (10) comprenant deux côtés de châssis (1, 2), les rouleaux (7, 8) s'étendant entre les côtés de châssis (1, 2) et étant montés dans les côtés de châssis (1, 2), et
les côtés de châssis (1, 2) étant reliés de manière monobloc par des entretoises transversales (11), les entretoises transversales (11) étant fabriquées conjointement avec les côtés de châssis (1, 2) par fabrication additive.

2. Châssis de laminoir (10) selon la revendication 1, **caractérisé en ce que** le châssis de laminoir (10) est conçu comme une unité mobile entraînable lors d'un processus de laminage.

3. Châssis de laminoir selon la revendication 2, **caractérisé en ce que** le châssis de laminoir (10) est conçu comme un châssis de laminoir à froid.

4. Châssis de laminoir selon la revendication 3, **caractérisé en ce qu'**au moins un maneton (6) est monté sur le châssis de laminoir (10) pour déplacer le châssis de laminoir (10), le maneton (6) n'étant notamment pas formé par fabrication additive.

5. Châssis de laminoir selon l'une des revendications précédentes, **caractérisé en ce qu'**une forme du châssis de laminoir est optimisée en termes de masse et/ou de résistance par une optimisation informatique utilisant la méthode des éléments finis.

6. Procédé d'amélioration d'une installation de laminage existante, comprenant les étapes suivantes :
a. enregistrement des paramètres de cadre d'un châssis de laminoir existant (1, 2, 3) ;
b. conception d'un châssis de laminoir (10) optimisé en termes de masse et/ou de résistance, en respectant les paramètres de cadre enregistrés à l'étape a ;
c. fabrication d'un nouveau châssis de laminoir (10) par fabrication additive selon l'une des revendications précédentes ;
d. remplacement du châssis de laminoir existant (1, 2, 3) par le nouveau châssis de laminoir (10).
